# EUROPEAN PATENT APPLICATION

(11) **EP 2 735 847 A2**
(43) Date of publication of application: **28.05.2014**
(21) Application number: 13186765.7
(22) Date of filing: 30.09.2013
(51) Int. Cl.: G01D 4/00

(54) **Apparatus and method for non-intrusive load monitoring (NILM)**

(30) Priority: 22.11.2012 KR 20120132925
(71) Applicant: Samsung Electronics Co., Ltd, Gyeonggi-do 443-742 (KR)
(72) Inventor: Park, Young Jin, Gyeonggi-do (KR); Rabi, Mohanlal, Gyeonggi-do (KR); Seo, Sung Mok, Seoul (KR); Shin, Jong Hyun, Gyeonggi-do (KR)
(74) Representative: Brandon, Paul Laurence

(57) **Abstract**

An apparatus and method for non-intrusive load monitoring (NILM). The NILM apparatus is aimed at updating reference data of a storage unit established by a generalized method to increase reliability of the storage unit. The NILM apparatus includes: a sensor unit configured to collect information about power consumed by an appliance; a controller configured to acquire a power consumption pattern of the appliance based on the collected power information, and to identify the appliance using the power consumption pattern; a display unit configured to display the result of the identification so as for a user to determine whether the result of the identification using the power consumption pattern is correct; and storage unit configured to store the result of the identification if it is determined that the result of the identification displayed on the display unit is correct.

## Description

### BACKGROUND

### 1. Field

The following description relates to non-intrusive load monitoring (NILM) technology to detect the operating state of an appliance through a single point sensor to estimate consumption power of the appliance.

### 2. Description of the Related Art

In order to successfully introduce a smart grid for stable and efficient use of electrical energy to individual homes, understanding and participation of consumers as well as power producers and energy policy makers are important. In view of consumers, the benefit of the smart grid is savings of electricity bill, which may be easily achieved through energy savings.

Energy saving methods discussed in research related to the smart grid may be classified into a method of feeding back the current state of energy consumption to consumers and inducing the consumers to participate in reducing energy consumption, and a method of automatically reducing energy consumption while consumers do not recognize it. Analysis on effects of the method of feeding back the current state of energy use to consumers has been performed by the Electric Power Research Institute (EPRI) of the U.S, and the research results show that the effect of energy savings may be attained by just providing power consumption patterns to users, and particularly, that when information about individual appliances is provided in real time, on the average, the effect of energy savings of about 12% may be obtained.

The method of automatically reducing energy consumption while consumers do not recognize it is implemented in such a manner to concentrate energy consumption when electric charge is low by connecting appliances corresponding to a smart grid through a home area network (HAN) and causing the HAN to interwork with a demand control program of a power company through a smart meter. The method of automatically reducing energy consumption is attractive to consumers because of its convenience, however, the method requires the power company to execute the demand control program, and replacement of all watt-hour meters and appliances with smart devices corresponding to a smart grid.

The method of transferring power consumption information about individual appliances to users in real time to induce the users to voluntarily save energy is an effective method for energy savings, however, establishing a system for the method needs high costs. A general method of establishing an energy monitoring system is to install a power consumption sensing device called a smart plug or a smart socket in each appliance, collect information about a power ratio through a wireless communication means, and display the collected information on an In-Home Display (IHD) functioning as a sink. However, in order to install smart plugs in individual appliances and manage them, high equipment costs and great effort are needed. In order to reduce such costs, instead of using smart plugs, studies into non-intrusive load monitoring (NILM) technology of monitoring a power line to which all home appliances have been connected, observing a mixed power signal to which the power use patterns of the appliances have been mixed, separating the power consumption patterns of the respective appliances from the observed, mixed power signal, and providing the separated power consumption patterns to users have been conducted.

In the NILM technology, appliances should be able to be identified (distinguished) in order to separate their power consumption patterns, and accordingly, a process of comparing the power consumption patterns of appliances with reference data established in database is needed. A method of establishing database with reference data includes a training method and a generalized method. The training method, which is a method discussed at the initial stage of NILM technology development, is to acquire and accumulate the characteristic information of appliances that consume power in homes (or workplaces) to which the NILM technology will be applied, by turning on/off the appliances one by one. That is, in the training method, a user himself or herself inputs information about each appliance, the information extracted by repeatedly turning on/off the appliance when only the appliance is plugged in while the other appliances connected to a panel board are plugged off. The training method may acquire relatively reliable database, but involves inconvenience since a user's manipulations are necessarily required, resulting in limitation on commercialization. Accordingly, generally, a provider of the NILM technology, instead of users, performs the training procedure. However, since various kinds of appliances installed in homes (or workplaces) are generally different in term of manufacturing company, model number, capacity, etc., it is difficult to establish reliable database by once performing the training procedure. The generalized method may reduce the disadvantage of the training method to some degree since a plurality of appliances are selected and trained and then characteristics appearing in common in the appliances are generalized and established as database.

However, both the training method and the generalized method have the following problems. Since the training method should be performed by users or electricians and should measure the characteristic information of each appliance to be trained while supplying power only to the corresponding appliance after electrically isolating the other appliances connected to an electric outlet, in the case of an appliance such as a refrigerator, the stored food may go bad. Also, in the case of repeatedly measuring the characteristic information of appliances in order to increase accuracy of training, the time consumed for training may be all day or several days. The problem becomes more significant as the number of target appliances increases. This is a large roadblock to commercialization. The generalized method has an advantage that a provider for NILM may establish database by obtaining characteristics representing appliances in advance through a training procedure, however, the generalized method has, as described above, a problem that reliability of the database is not high since appliances are different in terms of manufacturing company, model number, kinds of products, installation environment. That is, the same appliance may show different characteristic information according to a place (environment) in which it is installed.

### SUMMARY

Therefore, it is an aspect of the present disclosure to provide a non-intrusive load monitoring (NILM) apparatus capable of updating reference data of database established by a generalized method to increase reliability of the database.

Additional aspects of the disclosure will be set forth in part in the description which follows and, in part, will be obvious from the description, or may be learned by practice of the disclosure.

In accordance with one aspect of the present disclosure, a non-intrusive load monitoring (NILM) apparatus includes: a sensor unit configured to collect information about power consumed by an appliance; a controller configured to acquire a power consumption pattern of the appliance based on the collected power information, and to identify the appliance based on the power consumption pattern; a display unit configured to display a result of the identification so as for a user to determine whether the result of the identification using the power consumption pattern is correct; and database configured to store the result of the identification if it is determined that the result of the identification displayed on the display unit is correct.

The result of the identification may include a power use pattern of the appliance, and the name of the appliance determined to correspond to the power use pattern.

The NILM apparatus may further include an input unit, wherein the user determines the result of the identification by providing an input to confirm the result of the identification displayed on the display unit through the input unit if the power consumption pattern displayed on the display corresponds to the name of the appliance.

The result of the identification may include at least one of a power use time of the appliance, consumption power representing a quality of power consumed for the power use time, and the result of analysis representing the name of the appliance.

The NILM apparatus may further provide, if the name of an appliance actually used for the power use time does not correspond to the name of the appliance displayed as the result of the analysis, a scroll function is provided to allow the user to search for the name of the appliance actually used for the power use time and to select the name of the appliance actually used using the scroll function.

When the result of the identification is displayed on the display unit, a guide message includes an instruction for at least one of movement, selection, and termination.

If there is no user response regarding the determination for a predetermined time period, the data corresponding to the result of the identification may be deleted.

The database may be updated by reflecting the result of the identification.

The NILM apparatus may be installed in a panel board, and configured to operate by receiving power through the panel board.

The NILM apparatus may be provided in a form of an independent device configured to operate by receiving power through at least one of an electric outlet and a power strip connected to a power line supplied through a panel board, and the NILM apparatus is configured to operate by receiving power through the panel board.

The NILM apparatus may be integrated with the display unit.

The NILM apparatus may be configured to use another apparatus including a screen to display at least one of image information and text information, and an input device to receive a user's input.

The another apparatus including the screen and the input device may include at least one of a television, a personal computer, a notebook, a laptop, a web pad, a smart phone, a mobile device and a tablet.

The NILM apparatus may be provided in a form of an independent device configured to operate by receiving power through at least one of an electric outlet and a power strip connected to a power line supplied through a panel board, the NILM apparatus operating by receiving power through the panel board, wherein the NILM apparatus may be configured to use another apparatus including a screen to display at least one of image information and text information, and an input device to receive a user's input.

In accordance with another aspect of the present disclosure, a non-intrusive load monitoring (NILM) method includes: collecting information about power consumed by an appliance; acquiring a power consumption pattern of the appliance based on the collected power information; identifying the appliance using the power consumption pattern; displaying a result of the identification; determining whether the result of the identification using the power consumption pattern is correct by a user; and storing the result of the identification in database if it is determined that the result of the identification displayed on the display unit is correct.

The result of the identification may include a power use pattern of the appliance, and the name of the appliance determined to correspond to the power use pattern.

The determining of the result of the identification may include the user providing an input to confirm the result of the identification displayed on the display unit through an input unit if the power consumption pattern displayed on the display corresponds to the name of the appliance.

The result of the identification may include at least one of a power use time of the appliance, consumption power representing a quality of power consumed for the power use time, and the result of analysis representing the name of the appliance.

The NILM method may further provide, if the name of an appliance actually used for the power use time does not correspond to the name of the appliance displayed as the result of the analysis, a scroll function is provided to allow the user to search for the name of the appliance actually used for the power use time and to select the name of the appliance actually used using the scroll function.

The displaying of the result of the identification on the display unit may further include displaying a guide message for the scroll function is displayed, the guide message includes an instruction for at least one of movement, selection, and termination.

If there is no user response regarding the determination, for a predetermined time period, the data corresponding to the result of the identification may be deleted.

The NILM method may further include updating the database by reflecting the result of the identification to the database.

Therefore, it is possible to overcome limitation of an existing training method in which a user should establish database of a NILM apparatus, and to reduce dependency of NILM on an environment to which the NILM is subject, thereby improving marketability and reliability of a NILM apparatus.

### BRIEF DESCRIPTION OF THE DRAWINGS

These and/or other aspects of the disclosure will become apparent and more readily appreciated from the following description of the embodiments, taken in conjunction with the accompanying drawings of which:
FIG. 1 shows a power supply system of supplying power to home (or a workplace) through a panel board, according to an embodiment of the present disclosure;
FIG. 2 schematically shows a power supply system including a non-intrusive load monitoring (NILM) apparatus according to a first embodiment of the present disclosure;
FIG. 3 is a block diagram showing the configuration of the NILM apparatus according to a first embodiment of the present disclosure;
FIG. 4 schematically shows a power supply system including a NILM apparatus according to a second embodiment of the present disclosure;
FIG. 5 is a block diagram showing the configuration of the NILM apparatus according to the second embodiment of the present disclosure;
FIG. 6 schematically shows a power supply system including a NILM apparatus according to a third embodiment of the present disclosure;
FIG. 7 is a block diagram showing the configuration of the NILM apparatus according to the third embodiment of the present disclosure;
FIG. 8 schematically shows a power supply system including a NILM apparatus according to a fourth embodiment of the present disclosure;
FIG. 9 is a block diagram showing the configuration of the NILM apparatus according to the fourth embodiment of the present disclosure;
FIG. 10 shows an embodiment of an interface for a user feedback, which is implemented through a display unit and an input unit, in a NILM apparatus according to an embodiment of the present disclosure;
FIG. 11 is a flowchart showing a control method of a NILM apparatus, according to an embodiment of the present disclosure; and
FIG. 12 is a flowchart showing a process for a user feedback and database updating shown in FIG. 11.

### DETAILED DESCRIPTION

Reference will now be made in detail to embodiments of the present disclosure, examples of which are illustrated in the accompanying drawings, wherein like reference numerals refer to like elements throughout.

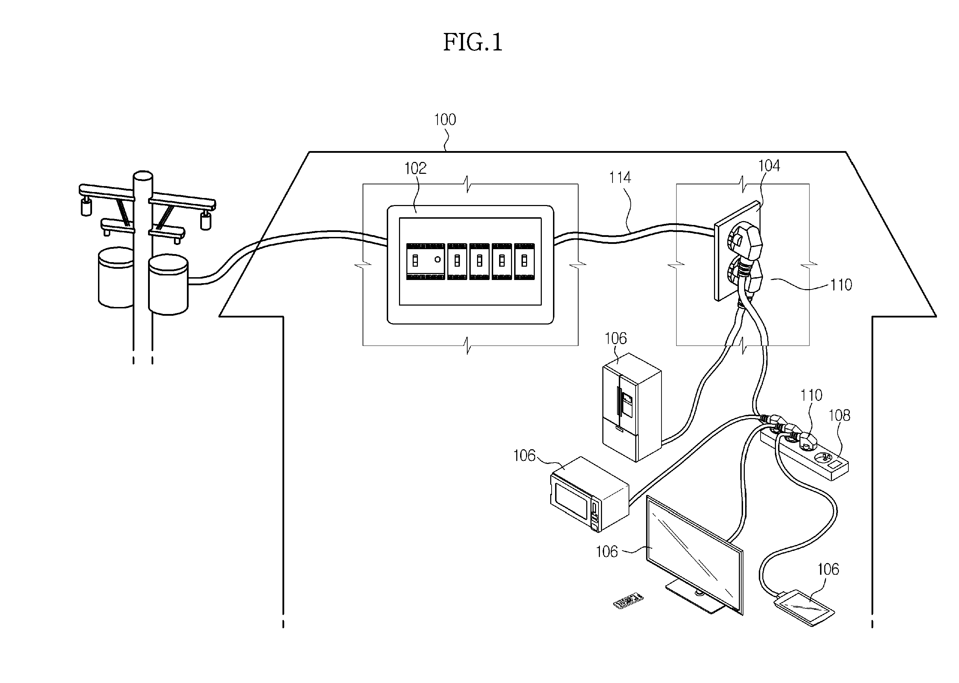

FIG. 1 shows a power supply system of supplying power to home (or a workplace) through a panel board, according to an embodiment of the present disclosure. As shown in FIG. 1, power supplied to a home (or a workplace) 100 from an external power source is transferred via wire 114 to a wall socket or an electric outlet 104 installed in at least one room, for example, a bedroom, a kitchen, etc. via a panel board 102 of the home (or the workplace) 100. Appliances 106 is connected to the electric outlet 105 using a plug 110. Appliances 106 that operate using the supplied power as energy, receive power directly through the electric outlet 104 or through a power strip or power outlet 108 connected to the electric outlet 104. The appliances 106 correspond to loads that consume power.

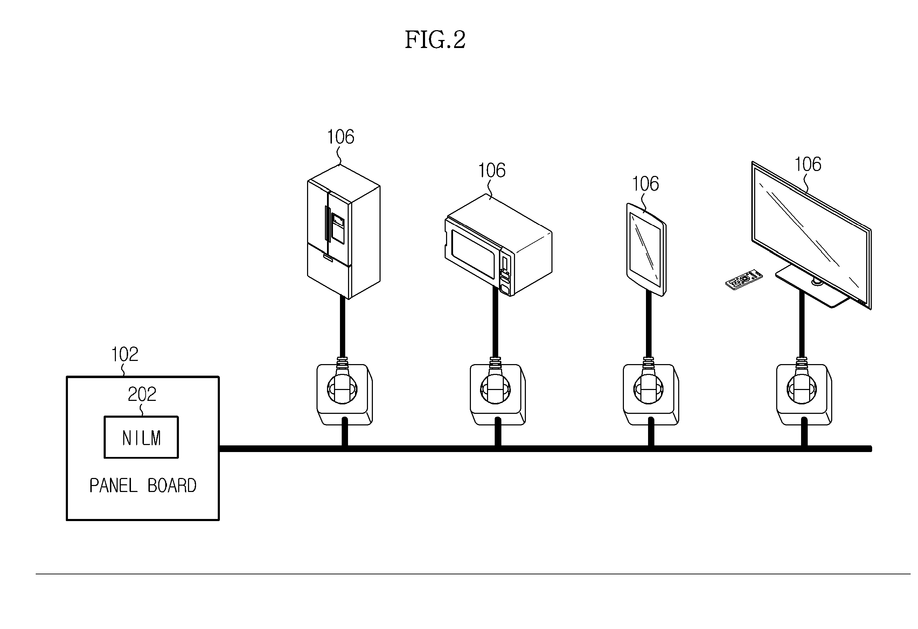

FIG. 2 schematically shows a power supply system including a non-intrusive load monitoring (NILM) apparatus 202 according to a first embodiment of the present disclosure. As shown in FIG. 2, appliances 106 that operate using power as energy, receive power from the panel board 102. The panel board 102 includes the NILM apparatus 202. The NILM apparatus 202 is used to analyze changes in voltage and current on a power line that supplies power to home (or a workplace), thus determining a power consumption pattern of the home (or the workplace), for example, determining what appliances 106 consume what quantity of power at what times in what patterns, based on the result of the analysis.

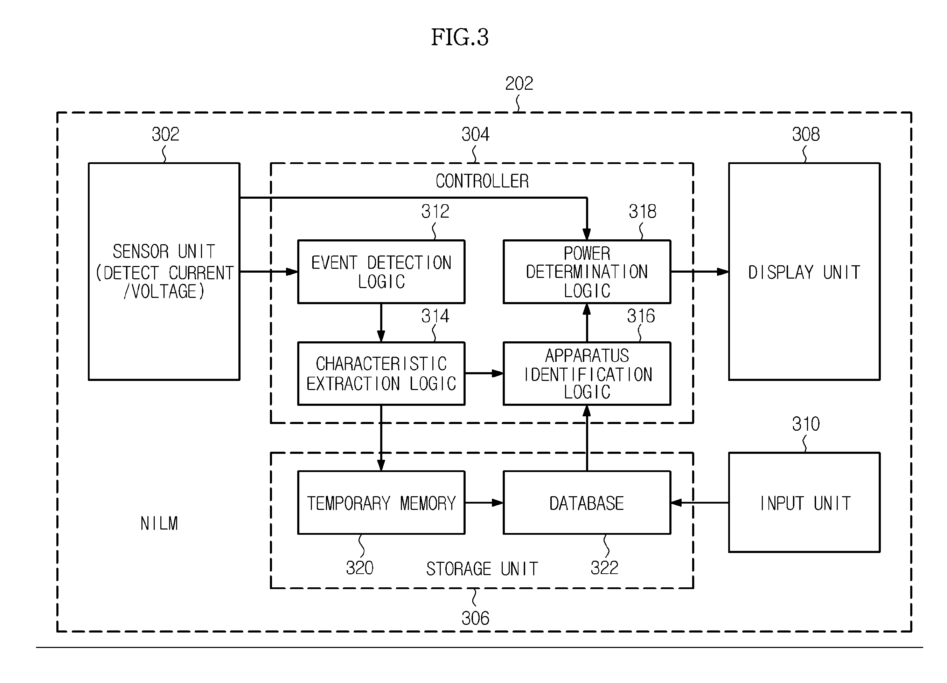

FIG. 3 is a block diagram showing the configuration of the NILM apparatus 202 according to the first embodiment of the present disclosure. As shown in FIG. 3, the NILM apparatus 202 according to the first embodiment of the present disclosure includes a sensor unit 302, a controller 304, a storage unit 306, a display unit 308, and an input unit 310. The sensor unit 302, the controller 304, the storage unit 306, the display unit 308, and the input unit 310 configure the NILM apparatus 202 which is an independent apparatus, through mechanical, electrical connections therebetween. For this, the sensor unit 302, the controller 304, the storage unit 306, the display unit 308, and the input unit 310 may be all contained in a single housing. However, the sensor unit 302 may be separated from the NILM apparatus 202, and installed in the panel board 102 or an electric outlet 104 (see FIG. 1). In this case, the sensor unit 302 may communicate with the NILM apparatus 202 through wired, wireless, or a wired-wireless hybrid communication, etc., and the NILM apparatus 202 and the sensor unit 302 may include communication modules, respectively.

In the NILM apparatus 202 shown in FIG. 3, the sensor unit 302 is used to measure changes (for example, changes in voltage and current) in electrical characteristics appearing on a power line 114 which is a path of transferring power to the appliances 106. The storage unit 306 includes a temporary memory 320 and database 322. The temporary memory 320 is used to temporarily store extracted unique characteristic information of the appliances 106. The database 322 stores reference data to identify0 various kinds of appliances, the reference data acquired through a test or learning. The reference data is data that will be compared to the extracted unique characteristics of the appliances 106 in order to determine whether the extracted unique characteristics of the appliances 106 are valid. Initial reference data of the database 322 before the NILM apparatus 202 is installed in a consumer's home (or workplace) is acquired in advance through a generalized method.

The controller 304 analyzes changes in electrical characteristics measured by the sensor unit 302, and estimates consumption power of the corresponding appliance 106 based on the result of the analysis. For this, the controller 304 includes an event detection logic 312, a characteristic extraction logic 314, an apparatus identification logic 316, and a power determination logic 318. The event detection logic 312 detects changes in effective power caused by on/off conversion, conversion in operating state, etc. of the appliances 106, and detects an event that is generated in the appliances 106. The characteristic extraction logic 314 extracts on/off times of the appliances 106 and unique characteristics of the power consumption patterns of the appliances 106, from raw data regarding changes in voltage and current measured through the sensor unit 302. For example, a washing machine has different power consumption patterns between when its spin basket rotates and when the spin basket does not rotate. Also, since the rotation speed of the spin basket is greatly different between when washing is done and when spin-drying is done, the corresponding power consumption patterns will be also greatly different. However, since a television shows a nearly constant power consumption pattern while it is powered on, the television has a power consumption pattern that is significantly different from that of the washing machine. The characteristic extraction logic 314 extracts such unique characteristics of each appliance 106, such as a power consumption pattern of the appliance 106. The apparatus identification logic 316 compares characteristic data (stored in the temporary memory 320) extracted by the characteristic extraction logic 314 to the reference data (stored in the database 322), and analyzes the result of the comparison to determine the kind of the corresponding appliance 106 and the operating state (for example, an on/off state or a specific operating state) of the appliance 106. The power determination logic 318 estimates a quantity of power consumption of the corresponding appliance 106, using power consumption information of the home (or, workplace), measured by the sensor unit 302, and on/off information of the appliance 106.

The display unit 308 and the input unit 310 are used for a user feedback. The display unit 308 displays the result of the identification regarding the appliance 106, the appliance 106 identified by the controller 304, so as for a user to determine the result of the identification. The input unit 310 receives the user's selection on the result of the identification displayed on the display unit 308, and transfers the user's selection to the controller 304. For example, the controller 304 displays power consumption information of the home (or workplace) and appliance identification information on the display unit 308 so that the user may check the power consumption information and the appliance identification information. Then, the user checks the power consumption information and the appliance identification information displayed on the display unit 308 to confirm whether the corresponding appliance identification information is correct, and inputs the result of the confirmation through the input unit 310. If the user has confirmed that the appliance identification information is correct, the controller 304 adds the appliance identification information (for example, power consumption characteristics and the name of an appliance corresponding to the power consumption characteristics) as new reference data to the database 322 of the storage unit 306, or updates existing reference data. Here, the user's selection or the user's confirmation is the concept of tagging or naming, and is operation of confirming the correspondence relationship between the appliance identification information and the corresponding appliance, and allocating (tagging or naming) the appliance's identifier or name to the correspondence relationship.

For example, the controller 304 determines that a certain appliance 106 operated at a specific time is a washing machine based on a power consumption pattern of the appliance 106, and displays the result of the determination (for example, identification) on the display unit 308 to inform the user of the result of the identification. At this time, the controller 304 determines to what degree the result of analysis on the power consumption pattern of the appliance 106 is identical or similar to data stored in the database 322. If the result of the analysis is identical of similar to the data stored in the database 322 by a predetermined degree or more, the controller 304 identifies the appliance 106 as an appliance corresponding to the stored data, whereas if the result of the analysis is not identical or not similar to the stored data by the predetermined degree, the controller 304 displays the result of the analysis on the display unit 308 to enable the user to determine the result of the analysis. If the appliance 106 operated at the specific time is actually a washing machine, the user makes an input of confirming that the corresponding appliance 106 is a washing machine, through the input unit 310. Then, the controller 304 adds the result of the identification and the name (for example, washing machine) of an appliance corresponding to the result of the identification as new reference data to the database 322, or updates existing reference data, based on the input from the user, so that when a power consumption pattern similar to the power consumption pattern is generated, the controller 304 may identify the corresponding appliance as a washing machine with reference to reference data of the database 322.

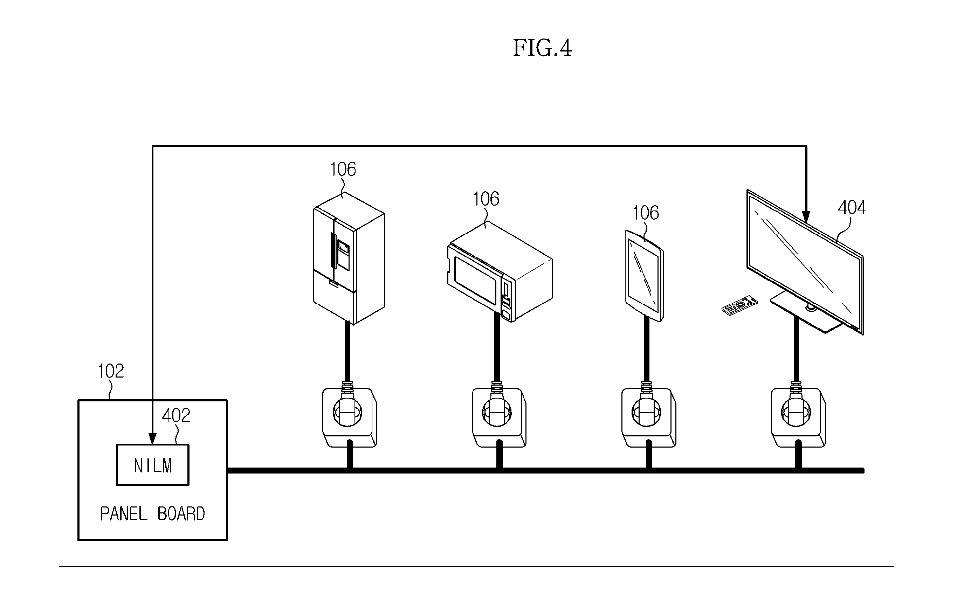

FIG. 4 schematically shows a power supply system including a NILM apparatus 402 according to a second embodiment of the present disclosure. As shown in FIG. 4, appliances 106 that use power as energy receive power from a panel board 102. The panel board 102 includes the NILM apparatus 402. The NILM apparatus 402 is used to analyze changes in voltage and current on a power line that supplies power to home (or a workplace), thus determining a power consumption pattern of the home (or the workplace), for example, determining what appliances 106 consume what quantity of power at what times in what patterns, based on the result of the analysis. Also, the NILM apparatus 402 uses an appliance (for example, a television) having a display unit and an input unit for a user feedback. That is, the NILM apparatus 402 may use another appliance or device having a screen to display at least one of image information and text information and an input device to receive a user's input, as a display unit and an input unit. In this case, the NILM apparatus 402 may include neither a display unit nor an input unit.

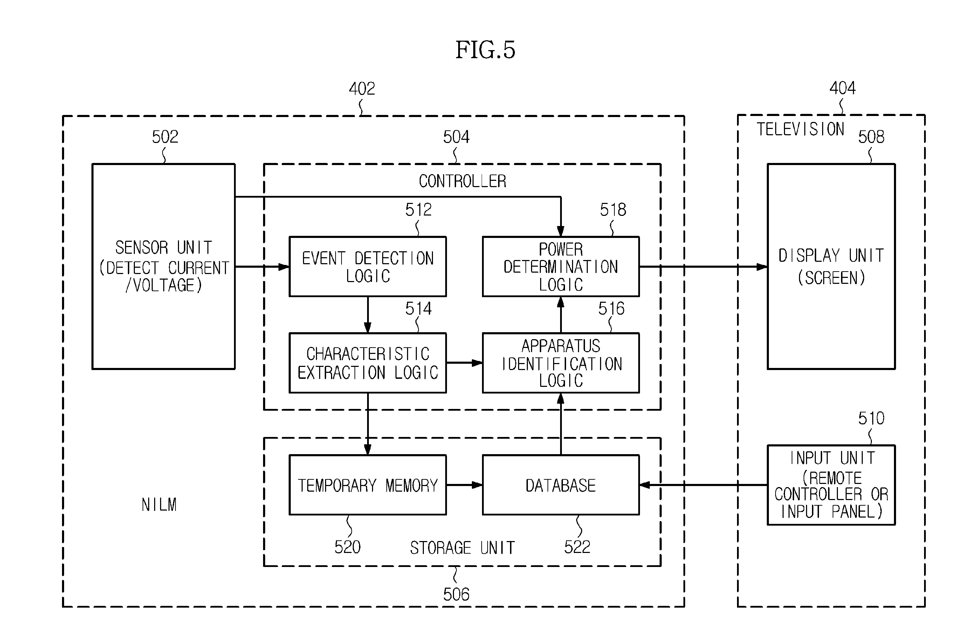

FIG. 5 is a block diagram showing the configuration of the NILM apparatus 402 according to the second embodiment of the present disclosure. As shown in FIG. 5, the NILM apparatus 402 includes a sensor unit 502, a controller 504, and a storage unit 506. The sensor unit 502, the controller 504, and the storage unit 506 configure the NILM apparatus 402 which is an independent apparatus, through mechanical, electrical connections therebetween. For this, the sensor unit 502, the controller 504, and the storage unit 506 may be all contained in a single housing. However, the sensor unit 502 may be separated from the NILM apparatus 402, and installed in the panel board 102 or the electric outlet 104 (see FIG. 1). In this case, the sensor unit 502 may communicate with the NILM apparatus 402 through wired, wireless, or wired-wireless hybrid communication, etc., and the NILM apparatus 402 and the sensor unit 502 may include communication modules, respectively.

In the NILM apparatus 402 shown in FIG. 5, the sensor unit 502 is used to measure changes (for example, changes in voltage and current) in electrical characteristics appearing on a power line which is a path of transferring power to appliances 106 (see FIG. 4). The storage unit 506 includes a temporary memory 520 and database 522. The temporary memory 520 is used to temporarily store extracted unique characteristic information of the appliances 106. The database 522 stores reference data to identify various kinds of appliances, the reference data acquired through a test or learning. The reference data is data that will be compared to the extracted unique characteristics of the appliances 106 in order to determine whether the extracted unique characteristics of the appliances 106 are valid. Initial reference data of the database 522 before the NILM apparatus 402 is installed in a consumer's home (or workplace) is acquired in advance through the generalized method.

The controller 504 analyzes changes in electrical characteristics measured by the sensor unit 502, and estimates consumption power of the corresponding appliance 106 based on the result of the analysis. For this, the controller 504 includes an event detection logic 512, a characteristic extraction logic 514, an apparatus identification logic 516, and a power determination logic 518. The event detection logic 512 detects, for example, changes in effective power caused by on/off conversion, conversion in operating state, etc. of the appliances 106, thus detecting an event generated in the appliance 106. The characteristic extraction logic 514 extracts on/off times of the appliances 106 and unique characteristics of the power consumption patterns of the appliances 106, from raw data regarding changes in voltage and current measured through the sensor unit 502. For example, a washing machine has different power consumption patterns between when its spin basket rotates and when the spin basket does not rotate. Also, since the rotation speed of the spin basket is greatly different between when washing is done and when spin-drying is done, the corresponding power consumption patterns are also greatly different. However, since a television shows a nearly constant power consumption pattern while it is powered on, the television has a power consumption pattern that is significantly different from that of the washing machine. The characteristic extraction logic 514 extracts such unique characteristics of each appliance 106, such as a power consumption pattern of the appliance 106. The apparatus identification logic 516 compares characteristic data (stored in the temporary memory 520) extracted by the characteristic extraction logic 514 to the reference data (stored in the database 522), and analyzes the result of the comparison to determine the kind of the corresponding appliance 106 and the operating state (for example, an on/off state or a specific operating state) of the appliance 106. The power determination logic 518 estimates a quantity of power consumption of the corresponding appliance 106, using power consumption information of the home (or, workplace), measured by the sensor unit 502, and on/off information of the appliance 106.

In the first embodiment described above with reference to FIGS. 2 and 3, the NILM apparatus 202 includes the display unit 308 and the input unit 310, whereas in the second embodiment, the NILM apparatus 402 implements a user feedback using an external display unit and an external input unit, instead of itself including a display unit and an input unit. For example, the NILM apparatus 402 may display the result of analysis by the controller 504 on a display unit 508 (for example, a screen) through communication with an appliance such as a television 404 having the display unit 508 and an input unit (for example, a remote controller or an input panel of a main body) 510, so as for a user to determine the result of the analysis. The input unit (the remote controller or the input panel) 510 receives the user's selection on the result of the analysis displayed on the display unit 508, and transfers the user's selection to the controller 504. In order to substitute for the display unit and input unit of the NILM apparatus 402, for example, a personal computer, a notebook, a laptop, a net book, a touch type web pad installed on a refrigerator, a smart phone, a tablet, a mobile device, and etc. may be used. The web pad, the smart phone, the tablet, etc. may receive touch inputs or pen inputs. As such, if the NILM apparatus 402 uses a display unit and an input unit installed on another appliance, instead of itself including a display unit and an input unit, the structure of the NILM apparatus 402 may be simplified, the size of the NILM apparatus 402 may be reduced, manufacturing costs may be reduced, and as a result, the N ILM apparatus 402 attains favorable conditions for commercialization.

The display unit 508 and the input unit 510 are used for a user feedback. The display unit 508 displays the result of analysis by the controller 504 to enable the user to determine the result of the analysis. The input unit 510 receives the user's selection on the result of the analysis displayed on the display unit 508, and transfers the user's selection to the controller 504. For example, the controller 504 displays power consumption information of home (or a workplace) and appliance identification information on the display unit 508 so that the user may check the power consumption information and the appliance identification information. The user checks the power consumption information and the appliance identification information displayed on the display unit 508 to confirm whether the corresponding appliance identification information is correct, and inputs the result of the confirmation through the input unit 510. If the user has confirmed that the appliance identification information is correct, the controller 504 adds the appliance identification information (for example, power consumption characteristics and the name of an appliance corresponding to the power consumption characteristics) as new reference data to the database 522 of the storage unit 506, or updates existing reference data. Here, the user's selection or the user's confirmation is the concept of tagging or naming, and is operation of confirming the correspondence relationship between the appliance identification information and the corresponding appliance, and allocating (tagging or naming) the appliance's identifier or name to the correspondence relationship.

For example, the controller 504 determines that a certain appliance 106 operated at a specific time is a washing machine based on a power consumption pattern of the appliance 106, and displays the result of the determination (for example, identification) on the display unit 508 to inform the user of the result of the identification. At this time, the controller 504 determines to what degree the result of analysis on the power consumption pattern of the appliance 106 is identical or similar to data stored in the database 522. If the result of the analysis is identical or similar to the data stored in the database 522 by a predetermined degree or more, the controller 504 identifies the appliance 106 as an appliance corresponding to the stored data, whereas if the result of the analysis is not identical or not similar to the stored data by the predetermined degree, the controller 504 displays the result of the analysis on the display 508 to enable the user to determine the result of the analysis. If the appliance 106 operated at the specific time is actually a washing machine, the user provides an input to confirm that the corresponding appliance 106 is a washing machine, through the input unit 510. Then, the controller 504 adds the result of the identification and the name (for example, washing machine) of an appliance corresponding to the result of the identification as new reference data to the database 522, or updates existing reference data, based on the input from the user, so that when a power consumption pattern similar to the power consumption pattern is generated, the controller 504 may identify the corresponding appliance as a washing machine with reference to reference data of the database 522.

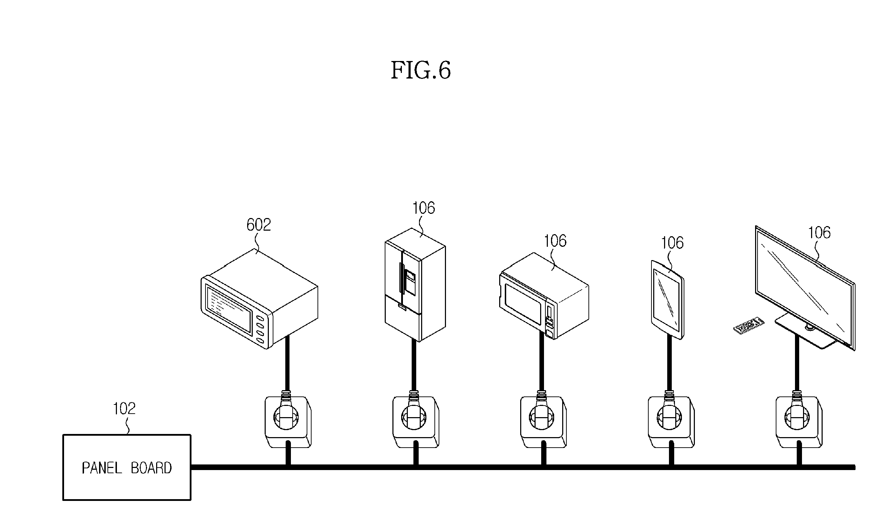

FIG. 6 schematically shows a power supply system including a NILM apparatus 602 according to a third embodiment of the present disclosure. As shown in FIG. 6, appliances 106 that operate using power as energy, receive power from a panel board 102. The NILM apparatus 602 according to the third embodiment of the present disclosure is not installed in the panel board 102, and operates by receiving power directly through an electric outlet 104 which is an independent device or through a power strip or power outlet 108 connected to the electric outlet 104. That is, the NILM apparatus 602 may be easily installed and removed. The NILM apparatus 602 is used to analyze changes in voltage and current on a power line that supplies power to home (or a workplace), thus determining a power consumption pattern of the home (or the workplace), for example, determining what appliances 106 consume what quantity of power at what times in what patterns, based on the result of the analysis.

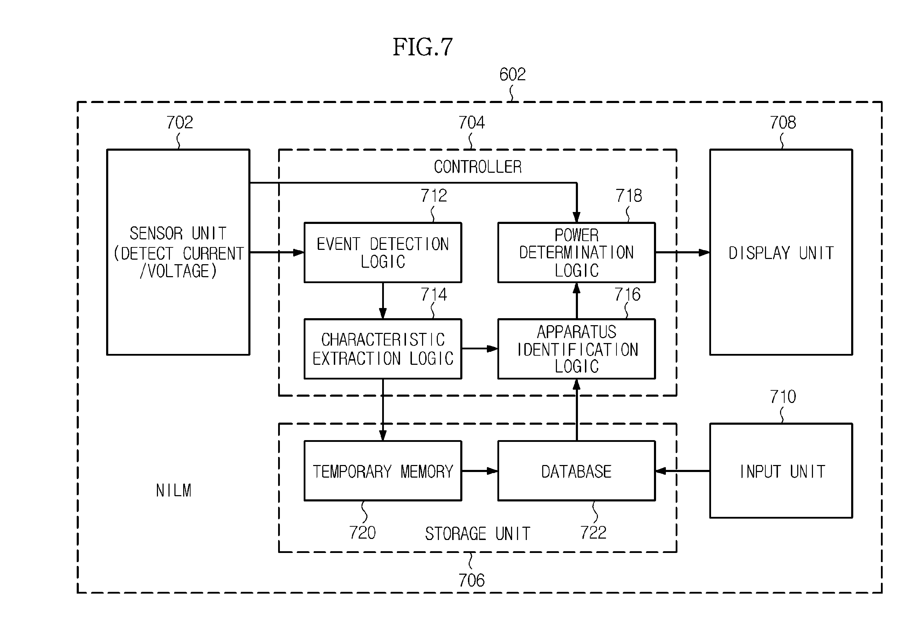

FIG. 7 is a block diagram showing the configuration of the NILM apparatus 602 according to the third embodiment of the present disclosure. As shown in FIG. 7, the NILM apparatus 602 according to the third embodiment of the present disclosure includes a sensor unit 702, a controller 704, a storage unit 706, a display unit 708, and an input unit 710. The sensor unit 702, the controller 704, the storage unit 706, the display unit 708, and the input unit 710 configure the NILM apparatus 602 which is an independent apparatus, through mechanical, electrical connections therebetween. For this, the sensor unit 702, the controller 704, the storage unit 706, the display unit 708, and the input unit 710 may be all contained in a single housing. However, the sensor unit 702 may be separated from the NILM apparatus 602, and installed in the panel board 102 (see FIG. 6) or the electric outlet 104 (see FIG. 1). In this case, the sensor unit 702 may communicate with the NILM apparatus 602 through wired/wireless communication, etc., and the NILM apparatus 602 and the sensor unit 702 may include communication modules, respectively.

In the NILM apparatus 602 shown in FIG. 7, the sensor unit 702 is used to measure changes (for example, changes in voltage and current) in electrical characteristics appearing on a power line which is a path of transferring power to appliances 106. The storage unit 706 includes a temporary memory 720 and database 722. The temporary memory 720 is used to temporarily store extracted unique characteristic information of the appliances 106. The database 722 stores reference data for identifying various kinds of appliances, the reference data acquired through a test or learning. The reference data is data that will be compared to the extracted unique characteristics of the appliances 106 in order to determine whether the extracted unique characteristics of the appliances 106 are valid. Initial reference data of the database 722 before the NILM apparatus 602 is installed in a consumer's home (or workplace) is acquired in advance through the generalized method.

The controller 704 analyzes changes in electrical characteristics measured by the sensor unit 702, and estimates consumption power of the corresponding appliance 106 based on the result of the analysis. For this, the controller 704 includes an event detection logic 712, a characteristic extraction logic 714, an apparatus identification logic 716, and a power determination logic 718. The event detection logic 712 detects changes in effective power caused by on/off conversion, conversion in operating state, etc. of the appliances 106, and detects an event that is generated in the appliances 106. The characteristic extraction logic 714 extracts on/off times of the appliances 106 and unique characteristics of the power consumption patterns of the appliances 106, from raw data regarding changes in voltage and current measured through the sensor unit 702. For example, a washing machine has different power consumption patterns between when its spin basket rotates and when the spin basket does not rotate. Also, since the rotation speed of the spin basket is greatly different between when washing is done and when spin-drying is done, the corresponding power consumption patterns will be also greatly different. However, since a television shows a nearly constant power consumption pattern while it is powered on, the television has a power consumption pattern that is significantly different from that of the washing machine. The characteristic extraction logic 714 extracts such unique characteristics of each appliance 106, such as a power consumption pattern of the appliance 106. The apparatus identification logic 716 compares characteristic data (stored in the temporary memory 720) extracted by the characteristic extraction logic 314 to the reference data (stored in the database 722), and analyzes the result of the comparison to determine the kind of the corresponding appliance 106 and the operating state (for example, an on/off state or a specific operating state) of the appliance 106. The power determination logic 718 estimates a quantity of power consumption of the corresponding appliance 106, using power consumption information of the home (or, workplace), measured by the sensor unit 702, and on/off information of the appliance 106.

The display unit 708 and the input unit 710 are used for a user feedback. The display unit 708 displays the result of analysis by the controller 704 to enable the user to determine the result of the analysis. The input unit 710 receives the user's selection on the result of the analysis displayed on the display unit 708, and transfers the user's selection to the controller 704. For example, the controller 704 displays power consumption information of home (or a workplace) and appliance identification information on the display unit 708 so that the user may check the power consumption information and the appliance identification information. The user checks the power consumption information and the appliance identification information displayed on the display unit 708 to confirm whether the corresponding appliance identification information is correct, and inputs the result of the confirmation through the input unit 710. If the user has confirmed that the appliance identification information is correct, the controller 704 adds the appliance identification information (for example, power consumption characteristics and the name of an appliance corresponding to the power consumption characteristics) as new reference data to the database 722 of the storage unit 706, or updates existing reference data. Here, the user's selection or the user's confirmation is the concept of tagging or naming, and is operation of confirming the correspondence relationship between the appliance identification information and the corresponding appliance, and allocating (tagging or naming) the appliance's identifier or name to the correspondence relationship.

For example, the controller 704 determines that a certain appliance 106 operated at a specific time is a washing machine based on a power consumption pattern of the appliance 106, and displays the result of the determination (identification) on the display unit 308 to inform the user of the result of the identification. At this time, the controller 704 determines to what degree the result of analysis on the power consumption pattern of the appliance 106 is identical or similar to data stored in the database 722, for example. If the result of the analysis is identical or similar to the data stored in the database 722 by a predetermined degree or more, the controller 704 identifies the appliance 106 as an appliance corresponding to the stored data, whereas if the result of the analysis is not identical or not similar to the stored data by the predetermined degree, the controller 704 displays the result of the analysis on the display 708 to enable the user to determine the result of the analysis. If the appliance 106 operated at the specific time is actually a washing machine, the user provides an input to confirm that the corresponding appliance 106 is a washing machine, through the input unit 710. Then, the controller 704 adds the identification result and the name (washing machine) of an appliance corresponding to the identification result as new reference data to the database 722, or updates existing reference data, based on the input from the user, so that when a power consumption pattern similar to the power consumption pattern is generated, the controller 704 may identify the corresponding appliance as a washing machine with reference to reference data of the database 722.

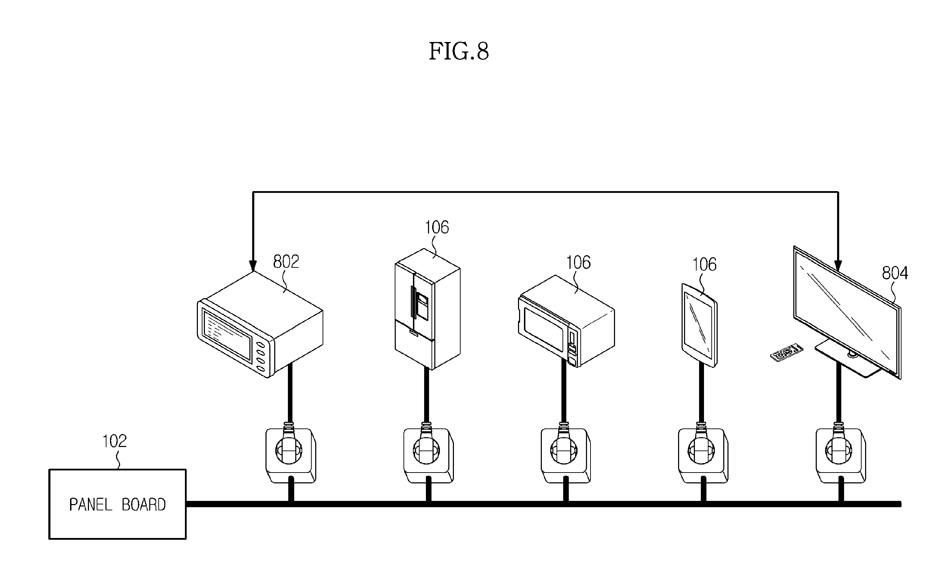

FIG. 8 schematically shows a power supply system including a NILM apparatus 802 according to a fourth embodiment of the present disclosure. As shown in FIG. 8, appliances 106 that operate using power as energy, receive power from a panel board 102. The N ILM apparatus 802 according to the fourth embodiment of the present disclosure is not installed in the panel board 102, and operates by receiving power directly through an electric outlet 104 (see FIG.1) which is an independent device or through a power strip or power outlet 108 (see FIG. 1) connected to the electric outlet 104. That is, the NILM apparatus 802 may be easily installed and removed. The NILM apparatus 802 is used to analyze changes in voltage and current on a power line that supplies power to home (or a workplace), thus determining a power consumption pattern of the home (or the workplace), for example, determining what appliances 106 consume what quantity of power at what times in what patterns, based on the result of the analysis.

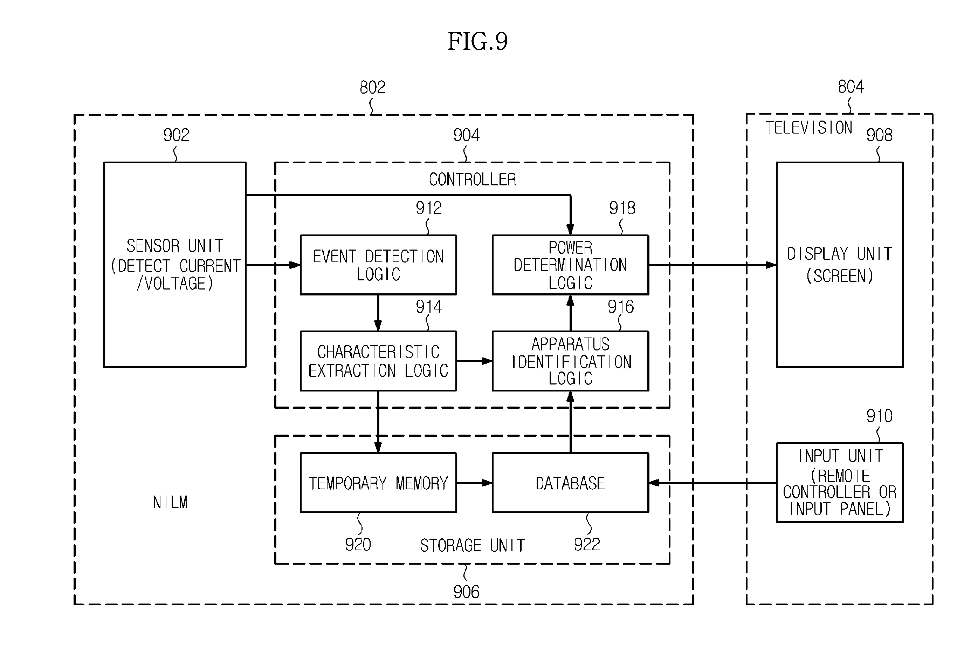

FIG. 9 is a block diagram showing the configuration of the NILM apparatus 802 according to the fourth embodiment of the present disclosure. As shown in FIG. 9, the NILM apparatus 802 according to the fourth embodiment of the present disclosure includes a sensor unit 902, a controller 904, and a storage unit 906. The sensor unit 902, the controller 904, and the storage unit 906 configure the NILM apparatus 802 which is an independent apparatus, through mechanical, electrical connections therebetween. For this, the sensor unit 902, the controller 904, and the storage unit 906 may be all contained in a single housing. However, the sensor unit 902 may be separated from the NILM apparatus 802, and installed in the panel board 102 (see FIG. 8) or the electric outlet 104 (see FIG. 1). In this case, the sensor unit 902 may communicate with the NILM apparatus 802 through wired, wireless, or wired-wireless hybrid communication, etc., and the NILM apparatus 802 and the sensor unit 902 may include communication modules, respectively.

In the NILM apparatus 802 shown in FIG. 9, the sensor unit 902 is used to measure changes (for example, changes in voltage and current) in electrical characteristics appearing on a power line which is a path of transferring power to the appliances 106. The storage unit 906 includes a temporary memory 920 and database 922. The temporary memory 920 is used to temporarily store extracted unique characteristic information of the appliances 106. The database 922 stores reference data to identify various kinds of appliances, the reference data acquired through a test or learning. The reference data is data that will be compared to the extracted unique characteristics of the appliances 106 in order to determine whether the extracted unique characteristics of the appliances 106 are valid. Initial reference data of the database 922 before the NILM apparatus 802 is installed in a consumer's home (or workplace) is acquired in advance through the generalized method.

The controller 904 analyzes changes in electrical characteristics measured by the sensor unit 902, and estimates consumption power of the corresponding appliance 106 based on the result of the analysis. For this, the controller 904 includes an event detection logic 912, a characteristic extraction logic 914, an apparatus identification logic 916, and a power determination logic 918. The event detection logic 912 detects changes in effective power caused by on/off conversion, conversion in operating state, etc. of the appliances 106, thus detecting an event generated in the appliances 106. The characteristic extraction logic 914 extracts on/off times of the appliances 106 and unique characteristics of the power consumption patterns of the appliances 106, from raw data regarding changes in voltage and current measured through the sensor unit 902. For example, a washing machine has different power consumption patterns between when its spin basket rotates and when the spin basket does not rotate. Also, since the rotation speed of the spin basket is greatly different between when washing is done and when spin-drying is done, the corresponding power consumption patterns will be also greatly different. However, since a television shows a nearly constant power consumption pattern while it is powered on, the television has a power consumption pattern that is significantly different from that of the washing machine. The characteristic extraction logic 914 extracts such unique characteristics of each appliance 106, such as a power consumption pattern of the appliance 106. The apparatus identification logic 916 compares characteristic data (stored in the temporary memory 920) extracted by the characteristic extraction logic 914 to the reference data (stored in the database 922), and analyzes the result of the comparison to determine the kind of the corresponding appliance 106 and the operating state (for example, an on/off state or a specific operating state) of the appliance 106. The power determination logic 918 estimates a quantity of power consumption of the corresponding appliance 106, using power consumption information of home (or, workplace), measured by the sensor unit 902, and on/off information of the appliance 106.

In the first embodiment described above with reference to FIGS. 2 and 3, the NILM apparatus 202 includes the display unit 308 and the input unit 310, whereas in the fourth embodiment, the NILM apparatus 802 implements a user feedback using an external display unit and an external input unit, instead of itself including a display unit and an input unit. For example, the NILM apparatus 802 may display the result of analysis by the controller 904 on a display unit (for example, screen) 908 through communication with an appliance such as a television 804 (see FIG. 8) having the display unit 908 and an input unit (a remote controller or an input panel of a main body) 910, so as for a user to determine the result of the analysis. The input unit (the remote controller or the input panel) 910 receives the user's selection on the result of the analysis displayed on the display unit 908, and transfers the user's selection to the controller 904. In order to substitute for the display unit and input unit of the NILM apparatus 802, a monitor and a keyboard of a personal notebook, a notebook, laptop, a net book, a touch type web pad installed on a refrigerator, a smart phone, a tablet, a mobile device, and etc., other than the television 804, may be used. The web pad, the smart phone, the tablet, etc. should be able to receive touch inputs or pen inputs. As such, if the NILM apparatus 802 uses a display unit and an input unit installed on another appliance or device, instead of itself including a display unit and an input unit, the structure of the NILM apparatus 802 may be simplified, the size of the NILM apparatus 802 may be reduced, manufacturing costs may be reduced, and as a result, the NILM apparatus 802 attains favorable conditions for commercialization.

The display unit 908 and the input unit 910 are used for a user feedback. The display unit 908 displays the result of analysis by the controller 504 to enable the user to determine the result of the analysis. The input unit 910 receives the user's selection on the result of the analysis displayed on the display unit 908, and transfers the user's selection to the controller 904. For example, the controller 904 displays power consumption information of home (or a workplace) and appliance identification information on the display unit 908 so that the user may check the power consumption information and the appliance identification information. The user checks the power consumption information and the appliance identification information displayed on the display unit 908 to confirm whether the corresponding appliance identification information is correct, and inputs the result of the confirmation through the input unit 910. If the user has confirmed that the appliance identification information is correct, the controller 904 adds the appliance identification information (for example, power consumption characteristics and the name of an appliance corresponding to the power consumption characteristics) as new reference data to the database 922 of the storage unit 906, or updates existing reference data. Here, the user's selection or the user's confirmation is the concept of tagging or naming, and is operation of confirming the correspondence relationship between the appliance identification information and the corresponding appliance, and allocating (tagging or naming) the appliance's identifier or name to the correspondence relationship.

For example, the controller 904 determines that a certain appliance 106 operated at a specific time is a washing machine based on a power consumption pattern of the appliance 106, and displays the result of the determination (for example, identification) on the display unit 908 to inform the user of the result of the identification. At this time, the controller 904 determines to what degree the result of analysis on the power consumption pattern of the appliance 106 is identical or similar to data stored in the database 922. If the result of the analysis is identical or similar to the data stored in the database 922 by a predetermined degree or more, the controller 904 identifies the appliance 106 as an appliance corresponding to the stored data, whereas if the result of the analysis is not identical or similar to the stored data by the predetermined degree, the controller 904 displays the result of the analysis on the display 908 to enable the user to determine the result of the analysis. If the appliance 106 operated at the specific time is actually a washing machine, the user provides an input to confirm that the corresponding appliance 106 is a washing machine, through the input unit 910. Then, the controller 904 adds the result of the identification and the name (for example, washing machine) of an appliance corresponding to the result of the identification as new reference data to the database 922, or updates existing reference data, based on the input from the user, so that when a power consumption pattern similar to the power consumption pattern is generated, the controller 904 may identify the corresponding appliance as a washing machine with reference to reference data of the database 922.

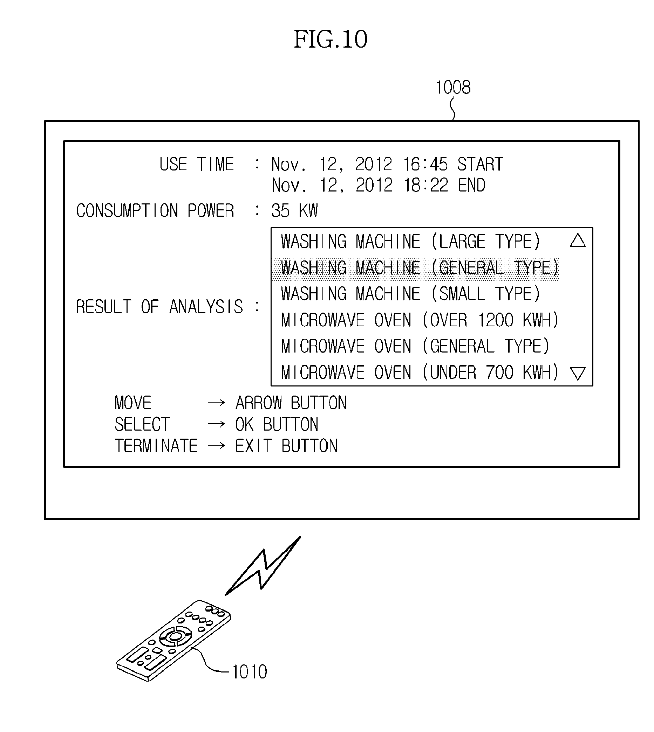

FIG. 10 shows an embodiment of an interface for a user feedback, which is implemented through a display unit 1008 and an input unit 1010, in a NILM apparatus according to an embodiment of the present disclosure. As shown in FIG. 10, the interface for the user feedback, which is displayed on the display unit 1008, displays main information that is to be provided to a user, such as a "use time" of the corresponding appliance (for example, a washing machine (general type)), "consumption power" that is predicted to be consumed for the use time, "result of analysis" of a power consumption pattern, etc. Also, below the main information, an interface guide, such as "Move→ Arrow Button", "Select → OK Button", and "Termination→Exit Button", is displayed. According to the display content of the interface shown in FIG. 10, use time of the washing machine (general type) is 1 hour and 37 minutes from Nov. 12, 2012 16:45 to Nov. 12, 2012 18:22, and consumption power consumed for the use time is 35KW. In the item of "result of analysis", an application name (in the current embodiment, "washing machine (general type)") to be informed to a user is highlighted. If an appliance used between Nov. 12, 2012 16:45 and Nov. 12, 2012, 18:22 is not a washing machine (general type), the user may manipulate "arrow button" of the input unit 1010 to move highlight to another appliance which he or she wants to select, and then select the corresponding appliance using "OK button". After selecting the appliance, the user may manipulate "exit button" to terminate user feedback operation.

The interface for the user feedback as shown in FIG. 10 may be displayed on a display unit installed on a NILM apparatus, or on a display unit of an appliance, such as a television, a personal computer, a notebook computer, a touch type web pad installed on a refrigerator, a smart phone, a tablet, a mobile device, and etc. In this case, the content and display format of the user interface may depend on the feature of an appliance on which the display unit is installed. In the case of a television, for example, a remote controller or an input panel of the television main body may be used as an input unit, and in the case of a personal computer or a notebook computer, for example, a keyboard or mouse may be used as the input unit. In the case of a web pad, a smart phone, or a tablet, a touch input or a pen input that is input to a screen may be used as the input unit.

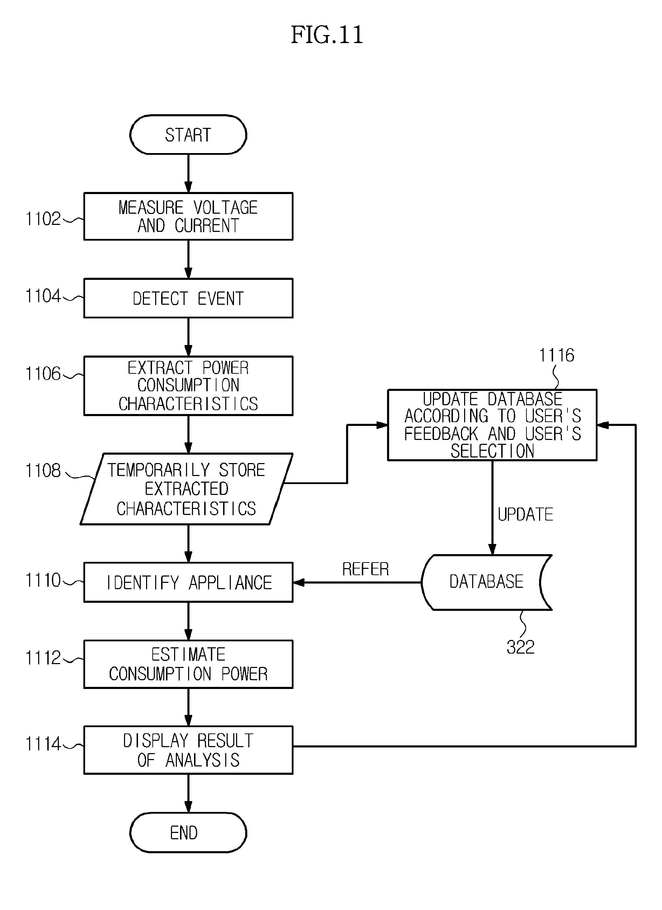

FIG. 11 is a flowchart showing a control method of a NILM apparatus, according to an embodiment of the present disclosure. According to the control method shown in FIG. 11, the NILM apparatus displays the result of analysis about a power consumption pattern for a user through a display unit, receives the user's response to the displayed analysis result, and adds/updates data of database. The control method shown in FIG. 11 may be performed by one of the NILM apparatuses according to the first, second, and third embodiments of the present disclosure as described above. In order to describe the control method shown in FIG. 11, it is assumed that the control method is performed by the NILM apparatus 202 according to the first embodiment of the present disclosure as shown in FIGS. 2 and 3.

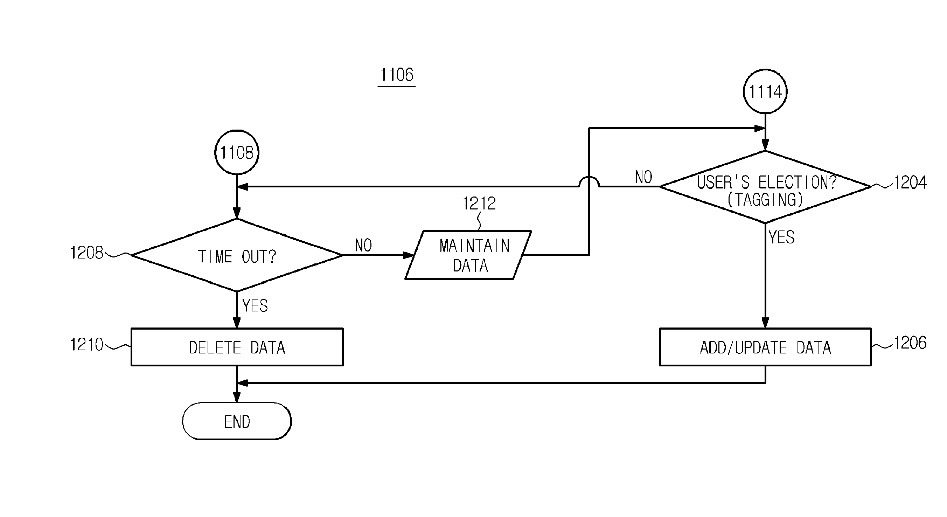

Referring to FIGS. 2, 3, and 11, the sensor unit 302 measures changes (for example, changes in voltage and current) in electrical characteristics appearing on a power line which is a path of transferring power that is supplied to an appliance 106 (1102). The controller 304 detects changes in effective power caused by on/off conversion, conversion in operating state, etc. of the appliance 106, from changes in electrical characteristics measured by the sensor unit 302 through the event detection logic 312, thus detecting an event that is generated in the appliance 106 (1104). Successively, the controller 304 extracts on/off times of the appliance 106 and unique characteristics of a power consumption pattern of the appliance 106, from raw data regarding changes in voltage and current measured through the sensor unit 302 (1106). For this, the controller 304 uses the characteristic extraction logic 314. The extracted characteristics are stored in the temporary memory 320 (1108). The controller 304 compares characteristic data of the temporary memory 320 to reference data of the database 322 through the apparatus identification logic 316, and analyzes the result of the comparison to determine the kind of the corresponding appliance 106 and the operating state of the appliance 106 (1110). In order to determine the kind of the corresponding appliance 106 and the operating state of the appliance 106, data of the database 322 is referred to. The controller 304 estimates a quantity of power consumption of the corresponding appliance 106, using consumption power information of home (or a workplace) 100 measured through the sensor unit 302, and on/off information of the appliance 106 (1112). In order to estimate a quantity of power consumption of the appliance 106, the power determination logic 318 is used. The controller 304 displays the result of the analysis through the display unit 308 so as for a user to determine the result of the analysis (1114). The result of the analysis displayed on the display unit 308 is used for a user feedback and to update the database 322 according to the user's selection (1116). The user feedback and database updating will be described in more detail with reference to FIG. 12.

FIG. 12 is a flowchart showing a process for a user feedback and database updating shown in FIG. 11. In operation 1114 of displaying the result of the analysis, the controller 304 compares the result of the analysis to data stored in the database 322, displays the result of the analysis on the display 308 if the result of the analysis is identical or similar to the data stored in the database by a predetermined degree or more, in order to enable the user to determine the result of the analysis, as described above. Thereafter, the controller 34 checks whether there is the user's input through the input unit 310 (1204). If the user provides an input to confirm the corresponding appliance 106 on an interface displayed on the corresponding display 308 since the user has determined that the result of the analysis corresponds to the predicted appliance, the controller 304 adds/updates the name of the appliance 106 and reference data created from the result of the analysis to the database 322 (1206). In detail, if the appliance 106 is a new appliance, the corresponding data will be added, and if the appliance 106 is an existing appliance, data of the existing appliance will be updated to new data.

The NILM apparatus 202 performs data validation to ensure free space of the temporary memory 320 by deleting data to which no response is received for a predetermined time period. That is, in operation 1108 of storing the extracted characteristics in the temporary memory 320 as shown in FIG. 11, if there is no user's response to data referred to be compared to data stored in the temporary memory 320 for a predetermined time period ("Yes" in operation 1208), the corresponding data is deleted from the temporary memory 320 (1210). However, the data stored in the temporary memory 320 is maintained until the predetermined time period elapses (1212). The operation of maintaining the data stored in the temporary memory 320 for the predetermined time period is provided in consideration of the case where a user's response (or selection) is not immediately received.

Although a few embodiments of the present disclosure have been shown and described, it would be appreciated by those skilled in the art that changes may be made in these embodiments without departing from the principles and spirit of the disclosure, the scope of which is defined in the claims and their equivalents.

## Claims

1. A non-intrusive load monitoring (NILM) apparatus comprising:
a sensor unit configured to collect information about power consumed by an appliance;
a controller configured to acquire a power consumption pattern of the appliance based on the collected power information, and to identify the appliance based on the power consumption pattern;
a display unit configured to display a result of the identification so as for a user to determine whether the result of the identification based on the power consumption pattern is correct; and
database configured to store the result of the identification if it is determined that the result of the identification displayed on the display unit is correct.

2. The NILM apparatus according to claim 1, wherein the result of the identification includes a power use pattern of the appliance, and the name of the appliance determined to correspond to the power use pattern.

3. The NILM apparatus according to claim 2, further comprising an input unit, wherein the user determines the result of the identification by providing an input to confirm the result of the identification displayed on the display unit through the input unit if the power consumption pattern displayed on the display corresponds to the name of the appliance.

4. The NILM apparatus according to claim 2, wherein the result of the identification includes at least one of a power use time of the appliance, consumption power representing a quality of power consumed for the power use time, and the result of analysis representing the name of the appliance.

5. The NILM apparatus according to claim 4, wherein if the name of an appliance actually used for the power use time does not correspond to the name of the appliance displayed as the result of the analysis, a scroll function is provided to allow the user to search for the name of the appliance actually used for the power use time and to select the name of the appliance actually used using the scroll function.

6. The NILM apparatus according to claim 4, wherein when the result of the identification is displayed on the display unit, a guide message for the scroll function is displayed, the guide message includes at least one of movement, selection, and termination is further displayed.

7. The NILM apparatus according to claim 1, wherein if there is no user response regarding the determination for a predetermined time period, the data corresponding to the result of the identification is deleted.

8. The NILM apparatus according to claim 1, wherein the database is updated by reflecting the result of the identification.

9. The NILM apparatus according to claim 1, wherein the NILM apparatus is installed in a panel board, and configured to operate by receiving power through the panel board.

10. The NILM apparatus according to claim 1, wherein the NILM apparatus is provided in a form of an independent device configured to operate by receiving power through at least one of an electric outlet and a power strip connected to a power line supplied through a panel board, and the NILM apparatus is configured to operate by receiving power through the panel board.

11. The NILM apparatus according to claim 1, wherein the NILM apparatus is integrated with the display unit.

12. The NILM apparatus according to claim 1, wherein the NILM apparatus is configured to use another apparatus including a screen to display at least one of image information and text information, and an input device to receive a user's input.

13. The NILM apparatus according to claim 12, wherein the other apparatus including the screen and the input device includes at least one of a television, a personal computer, a notebook, a laptop, a mobile device, a web pad, a smart phone, and a tablet.

14. The NILM apparatus according to claim 1, wherein the NILM apparatus is provided in a form of an independent device configured to operate by receiving power through at least one of an electric outlet and a multiple-tap connected to a power line supplied through a panel board, and the NILM apparatus is configured to operate by receiving power through the panel board,
wherein the NILM apparatus is configured to use another apparatus including a screen to display at least one of image information and text information, and an input device to receive a user's input.

15. A non-intrusive load monitoring (NILM) method comprising:
collecting information about power consumed by an appliance;
acquiring a power consumption pattern of the appliance based on the collected power information;
identifying the appliance based on the power consumption pattern;
displaying a result of the identification;
determining whether the result of the identification based on the power consumption pattern is correct by a user; and
storing the result of the identification in database if it is determined that the result of the identification displayed on the display unit is correct.
